# EUROPEAN PATENT APPLICATION

(11) **EP 2 075 590 A1**
(43) Date of publication of application: **01.07.2009**
(21) Application number: 07291636.4
(22) Date of filing: 28.12.2007
(51) Int. Cl.: G01R 31/36

(54) **Method and apparatus for monitoring and analyzing battery consumption in mobile communication devices**

(71) Applicant: MOTOROLA, INC., Schaumburg, IL 60196 (US)
(72) Inventor: Merat, Vincent, Aube 10440 (FR); Bok, Alan B., Naperville, Illinois 60540 (US); Buljore, Soodesh, Essone 91440 (FR); Chengeleroyen, Gemini B., Hauts De Seine 92160 (FR); Gorla, Vinod Kumar Yadav, Hauts De Seine 92160 (FR)
(74) Representative: Cross, Rupert Edward Blount

(57) **Abstract**

A method and apparatus that tracks battery consumption in a mobile communication device is disclosed. The method may include recording events occurring within in the mobile communication device (6200), measuring a battery level of the mobile communication device at a time of the recorded event (6300), logging the recorded events and the measured battery levels corresponding to the recorded events (6400), and outputting the logged corresponding events and measured battery levels for processing by a battery diagnostic server (6500). A method and apparatus that performs a diagnosis of a battery in a mobile communication device is also disclosed.

## Description

### BACKGROUND OF THE DISCLOSURE

### 1. Field of the Disclosure

The disclosure relates to remote monitoring and analyzing of battery consumption in mobile communication devices.

### 2. Introduction

One of the big concerns of mobile communication device users is battery life. Conventional mobile communication devices have no mechanism to detect and indicate that its battery is becoming defective. For example, a user may not recognize that the battery is charging slowly, discharging quickly and/or not charging after a certain leveL In addition, conventional mobile communication devices do not have a way to identify phone features or applications with excessive power consumption.

### SUMMARY OF THE DISCLOSURE

A method and apparatus that tracks battery consumption in a mobile communication device is disclosed. The method may include recording events occurring within the mobile communication device, measuring a battery level of the mobile communication device at a time of the recorded event, logging the recorded events and the measured battery levels corresponding to the recorded events, and outputting the logged corresponding events and measured battery levels for processing by a battery diagnostic server. A method and apparatus that performs a diagnosis of a battery in a mobile communication device is also disclosed. The method may include receiving a log with recorded events and battery levels corresponding to the recorded events from the mobile communication device, determining the mobile communication device model and type and corresponding features included with the mobile communication device, analysing the mobile communication device's battery based on the received log with recorded events and corresponding battery levels and the mobile communication device type and corresponding features, and determining if a battery defect exists based on the analysis of the mobile communication device's battery, wherein if a battery defect is determined to exist, sending a battery defect alert to the mobile communication device.

### BRIEF DESCRIPTION OF THE DRAWINGS

In order to describe the manner in which the above-recited and other advantages and features of the disclosure can be obtained, a more particular description of the disclosure briefly described above will be rendered by reference to specific embodiments thereof which are illustrated in the appended drawings. Understanding that these drawings depict only typical embodiments of the disclosure and are not therefore to be considered to be limiting of its scope, the disclosure will be described and explained with additional specificity and detail through the use of the accompanying drawings in which:

FIG. 1 illustrates a diagram of an exemplary mobile communications system in accordance with a possible embodiment of the disclosure;

FIG- 2 illustrates a block diagram of an exemplary mobile communication device in accordance with a possible embodiment of the disclosure;

FIG. 3 illustrates an exemplary block diagram of a battery consumption tracking module in accordance with a possible embodiment of the disclosure;

FIG. 4 illustrates a block diagram of an exemplary battery diagnostic server in accordance with a possible embodiment of the disclosure;

FIG. 5 illustrates an exemplary block diagram of a battery diagnostic module in accordance with a possible embodiment of the disclosure;

FIG. 6 is an exemplary flowchart illustrating one possible battery consumption tracking process in accordance with one possible embodiment of the disclosure; and

FIG. 7 is an exemplary flowchart illustrating one possible battery diagnostic process in accordance with one possible embodiment of the disclosure.

### DETAILED DESCRIPTION OF THE DISCLOSURE

Additional features and advantages of the disclosure will be set forth in the description which follows, and in part will be obvious from the description, or may be learned by practice of the disclosure. The features and advantages of the disclosure may be realized and obtained by means of the instruments and combinations particularly pointed out in the appended claims. These and other features of the present disclosure will become more fully apparent from the following description and appended claims, or may be learned by the practice of the disclosure as set forth herein.

Various embodiments of the disclosure are discussed in detail below. While specific implementations are discussed, it should be understood that this is done for illustration purposes only. A person skilled in the relevant art will recognize that other components and configurations may be used without parting from the spirit and scope of the disclosure.

The disclosure may comprise a variety of embodiments, such as a method and apparatus and other embodiments that relate to the basic concepts of the disclosure. This disclosure may concern providing a mechanism and process for being able to detect a defective battery, a defective charger, and excessive battery consumption. This process may permit a mobile communication device manufacturer to:
1. Proactively trigger the replacement of the user's battery/charger.
2. Assess that a battery defect reported by a user is really beyond the threshold above which a replacement should be done. For example, a defect may be: battery charging slowly, battery discharging quickly and battery not charging after a certain level.
3. Detect applications or phone features consuming too much battery power.

A battery defect may be detected based on the history of battery consumption. For example, if historically, many applications consume more and more battery or the battery consumption in idle mode is significant (i.e., when no user application is running), the battery defect may be suspected.

The disclosure may also propose to have a client-server architecture, allowing:
- The client (mobile communication device) to send an alert to the server on a detection of a battery failure or an excessive application power consumption;
- The server to query the mobile communication device for its battery consumption logs; and
- The server to send policies to the mobile communication device. The policies may be used by the mobile communication device for identifying the conditions (battery consumption thresholds) that should considered before sending an alert to the server.

The new functionality added to the mobile communication device includes logging battery consumption. To that aim, the mobile communication device must catch events occurring on the phone (e.g., application launch, incoming call, power on/off, etc.) and store in a log file the battery level when the event occurred. Events usually go via pairs: launch/shutdown of an application, answer/hang on a call, etc. Thus, for a given processing, the amount of battery consumed may be determined by computing the difference between the battery level at the entering event (for example, application launch) and the battery level at the leaving event (for example, application shutdown). The mobile communication device may also have the ability to:
-- manage policies related to battery consumption;
-- send an alert to the server; and
-- handle server requests.

The functionalities for the server may be:
-- handling of alerts coming from phones;
-- ability to initialize a connection with a phone for sending a policy or for asking logs;
-- provision of a user interface (UI) to allow creation of policies and triggering of log retrieval and analysis of the retrieved logs (by a Service Centre Agent or Quality Team Member for example);
-- storage of reference battery consumption based on specific criteria such as the phone model, the software version; and
-- per user storage of data coming from phones

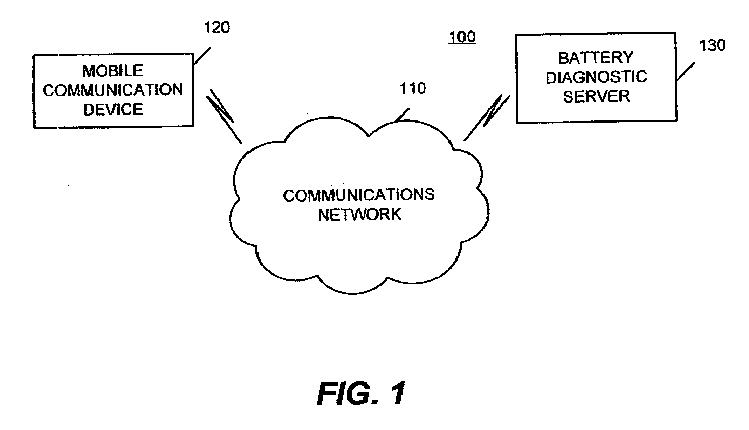

FIG. 1 illustrates a diagram of an exemplary mobile communications system 100 in accordance with a possible embodiment of the disclosure. In particular, the mobile communications system 100 may include a plurality mobile communication devices 120 and a batter diagnostic server 130 connected through communications network 110.

Communications network 110 may represent any possible communications network that may handle telephonic communications, including wireless telephone networks, hardwired telephone networks, wireless local area networks (WLAN), the Internet, an intranet, etc., for example.

The mobile communication device 120 may be any device with a battery and a charger, including a portable MP3 player, satellite radio receiver, AM/FM radio receiver, satellite television, portable music player, portable computer, wireless radio, wireless telephone, portable digital video recorder, cellular telephone, mobile telephone, personal digital assistant (PDA), or combinations of the above, for example. Although only one mobile communication device 120 is shown this is merely illustrative. There may be any number of mobile communication devices 120 in the mobile communications system 100.

The battery diagnostic server 130 may be a server, a computer, a personal computer, a portable computer, or a personal digital assistant, for example.

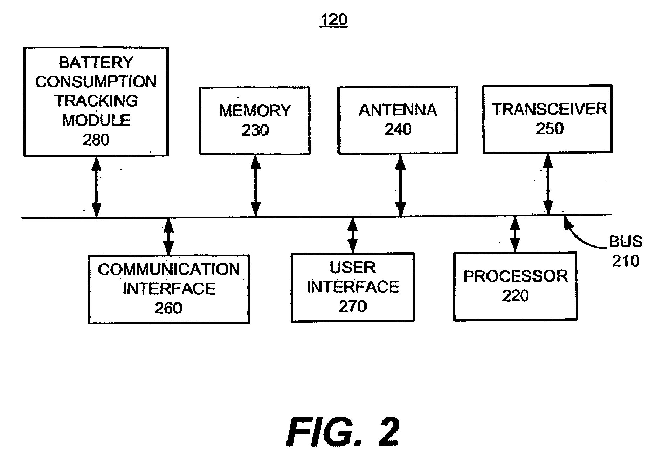

FIG. 2 illustrates a block diagram of an exemplary mobile communication device 120 in accordance with a possible embodiment of the disclosure. The exemplary mobile communication device 120 may include bus 210, processor 220, memory 230, antenna 240, transceiver 250, communication interface 260, user interface 270, and battery consumption tracking module 280. Bus 210 may permit communication among the components of the mobile communication device 120.

Processor 220 may include at least one conventional processor or microprocessor that interprets and executes instructions. Memory 230 may be a random access memory (RAM) or another type of dynamic storage device that stores information and instructions for execution by processor 220. Memory 230 may also include a read-only memory (ROM) which may include a conventional ROM device or another type of static storage device that stores static information and instructions for processor 220.

Transceiver 250 may include one or more transmitters and receivers. The transceiver 250 may include sufficient functionality to interface with any network or communications station and may be defined by hardware or software in any manner known to one of skill in the art. The processor 220 is cooperatively operable with the transceiver 250 to support operations within the communications network 110. In the mobile communication device 120, the transceiver 250 may transmit and receive transmissions via one or more of the antennae 240 in a manner known to those of skill in the art.

Communication interface 260 may include any mechanism that facilitates communication via the communications network 110. For example, communication interface 260 may include a modem. Alternatively, communication interface 260 may include other mechanisms for assisting the transceiver 250 in communicating with other devices and/or systems via wireless or hardwired connections.

User interface 270 may include one or more conventional input mechanisms that permit a user to input information, communicate with other communication devices and/or present information to the user, such as a an electronic display, microphone, touchpad, keypad, keyboard, mouse, pen, stylus, voice recognition device, buttons, one or more speakers, etc.

The mobile communication device 120 may perform such functions in response to processor 220 and/or battery consumption tracking module 280 by executing sequences of instructions contained in a computer-readable medium, such as, for example, memory 230. Such instructions may be read into memory 230 from another computer-readable medium, such as a storage device or from a separate device via communication interface 260.

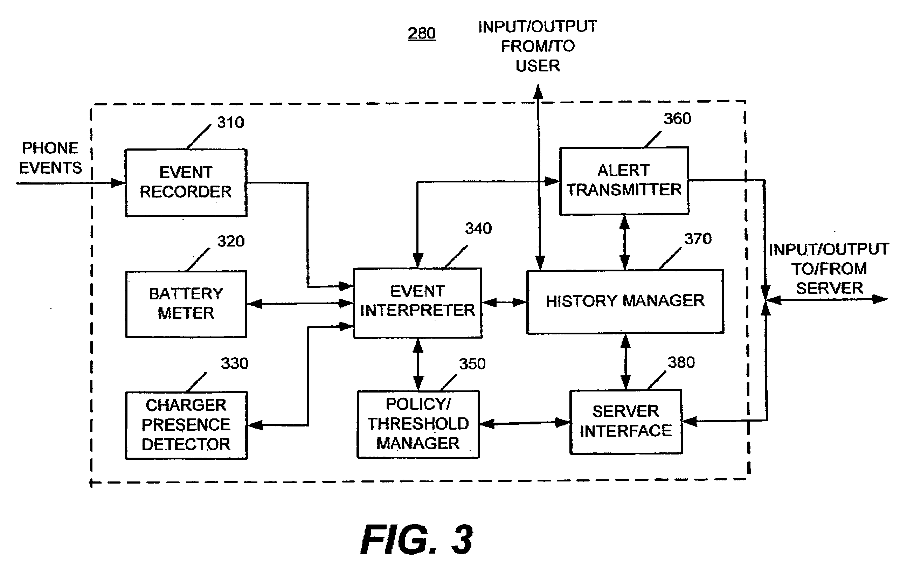

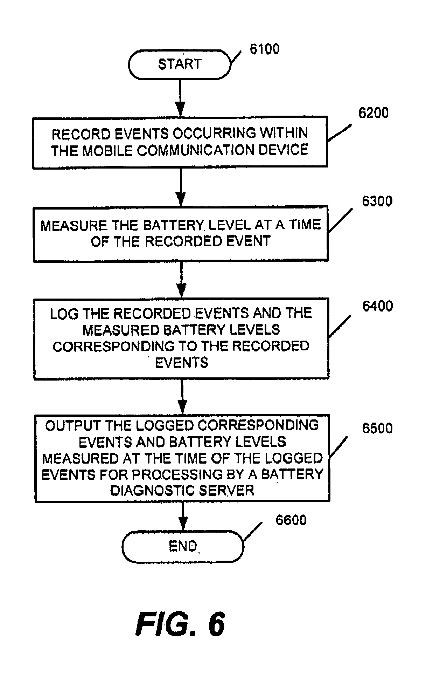

The operations and functions of the battery consumption tracking module 280 will be discussed in relation to FIGS. 3 and 6.

FIG. 3 illustrates an exemplary block diagram of a battery consumption tracking module 280 in accordance with a possible embodiment of the disclosure. The battery consumption tracking module 280 may include event recorder 310, battery meter 320, charger presence detector 330, event interpreter 340, policy/threshold manager 350, alert transmitter 360, history manager 370, and server interface 380.

The event recorder 310 may identify and record the events occurring on the mobile communication device 120, such as application launch/shutdown, turning on/off the mobile communication device 120, etc. Applications may include any functionality of the mobile communication device 120, including but not limited to telephone, Internet, text messaging, e-mail, MP3 player, radio, camera, Global Positioning System (GPS), calculator, calendar, etc., or any functions within these applications.

Battery meter 320 may measure the current battery level continuously, periodically, or when prompted remotely by the battery diagnostic server 130 or by another element of the battery consumption tracking module 280, such as the event interpreter 340, for example.

Event Interpreter 340 may receive inputs either directly or indirectly from another element of the battery consumption tracking module 280 such as the event recorder 310, the battery meter 320, the charger presence detector 330, the policy/threshold manager 350, the alert transmitter 360, and history manager 370, or remotely from the battery diagnostic server 130 through the server interface 380. The event interpreter 340 may update the logs of the mobile communication device 120 depending on the event type.

For example, if the mobile communication device 120 enters an application (i.e., a "start event"), then the event interpreter 340 may get the current battery level from the battery meter 320 and may add a new entry in the log structure stored via the history manager 370. A log entry may be made of the following attributes: Event name, start time, end time, battery level at start time, battery level at end time, flag telling if the entry's battery consumption is beyond the threshold define in the policies, etc.

If the mobile communication device 120 ends an application (i.e., an "end event"), then the event interpreter 340 may log an entry corresponding to the associated "start event" in the log structure stored via the history manager 370. The event interpreter 340 may compute the battery consumption during the period between the start and end events and log this computed value and the event name.

The event interpreter 340. may also determine whether the battery consumption is excessive or not based on input from the Policy/Threshold Manager 350. If the battery consumption is determined to be excessive, the event interpreter 340 may trigger the sending of an alert to the battery diagnostic server 130 using the alert transmitter 360, and/or send an alert to the user of the mobile communication device 120.

The event interpreter 340 may also receive input from the charger presence detector 330 concerning the presence of a battery charger. If the mobile communication device 120 is being charged by a charger during an event, this information may be considered when computing the battery consumption and may be useful in detecting a defective charger.

The history manager 370 may store (or cause to be stored in memory 230, for example) and manage logs related to battery consumption. A user may gain access to the log or battery statistics that may be stored using the history manager 370 through the user interface 270, for example. The server interface 380 may also gain access to the logs for transmission to the battery diagnostic server 130.

The policy/threshold manager 350 may store the policies/thresholds received from the battery diagnostic server 130 (or faetory-created policies/thresholds) and uses this stored data to determine if the event logged by the event interpreter 340 reveals excessive power consumption and/or battery defect.

The server interface 380 may handle the interaction with the battery diagnostic server 130. The server interface 380 may receive policy definitions and log requests from the battery diagnostic server 130. The server interface 380 may then send the logs requested by the battery diagnostic server 130 and send acknowledgements to the server for ensuring that a new policy has been acted upon. The server interface 380 may also receive commands coming from the battery diagnostic server 130. These commands may trigger the launch of an application, for example. This remote access through the server interface 380 may permit the battery diagnostic server 130 to diagnose the battery consumption of a specific application/phone feature and identify a batter defect.

The alert transmitter 360 may send an alert to the battery diagnostic server 130 or to the user of the mobile communication device 120. The content of this alert may be the name of the event associated with the alert, the value of the threshold it has overtaken, the historical values of the battery consumption for this event and the battery consumption in idle mode, for example.

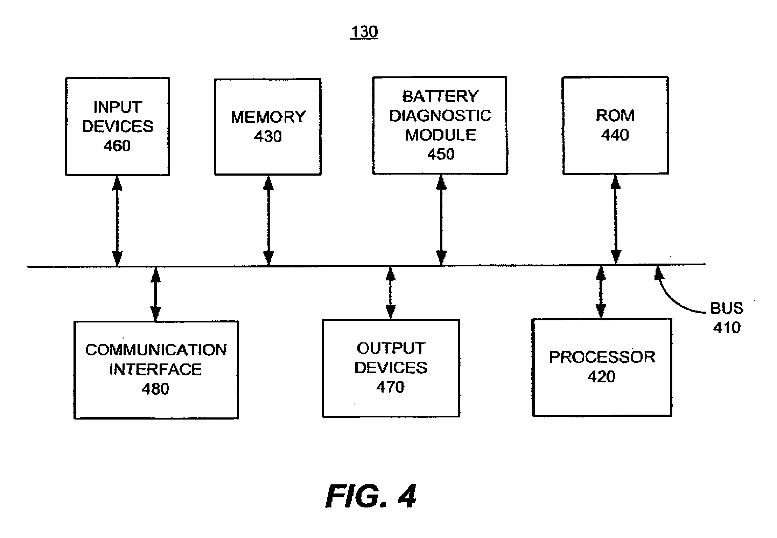

FIG. 4 illustrates a block diagram of an exemplary battery diagnostic server 130 in accordance with one possible embodiment of the disclosure. The battery diagnostic server 130 may include may include bus 410, processor 420, memory 430, read only memory (ROM) 440, battery diagnostic module 450, input devices 460, output devices 470, and communication interface 480. Bus 410 may permit communication among the components of the battery diagnostic server 130.

Processor 420 may include at least one conventional processor or microprocessor that interprets and executes instructions. Memory 430 may be a random access memory (RAM) or another type of dynamic storage device that stores information and instructions for execution by processor 420. Memory 430 may also include a read-only memory (ROM) which may include a conventional ROM device or another type of static storage device that stores static information and instructions for processor 420.

Communication interface 480 may include any mechanism that facilitates communication via a network. For example, communication interface 480 may include a modem. Alternatively, communication interface 480 may include other mechanisms for assisting in communications with other devices and/or systems.

ROM 440 may include a conventional ROM device or another type of static storage device that stores static information and instructions for processor 420. A storage device may augment the ROM and may include any type of storage media, such as, for example, magnetic or optical recording media and its corresponding drive.

Input devices 460 may include one or more conventional mechanisms that permit a user to input information to the battery diagnostic server 130, such as a keyboard, a mouse, a pen, a voice recognition device, touchpad, buttons, etc. Output devices 470 may include one or more conventional mechanisms that output information to the user, including a display, a printer, a copier, a scanner, a multi-function device, one or more speakers, or a medium, such as a memory, or a magnetic or optical disk and a corresponding disk drive.

The battery diagnostic server 130 may perform such functions in response to processor 420 by executing sequences of instructions contained in a computer-readable medium, such as, for example, memory 430. Such instructions may be read into memory 430 from another computer-readable medium, such as a storage device or from a separate devices via communication interface 480.

The battery diagnostic server 130 illustrated in FIGS. 1 and 4 and the related discussion are intended to provide a brief, general description of a suitable communication and processing environment in which the invention may be implemented Although not requited, the invention will be described, at least in part, in the general context of computer-executable instructions, such as program modules, being executed by the battery diagnostic server 130, such as a communication server, communications switch, communications router, or general purpose computer, for example.

Generally, program modules include routine programs, objects, components, data structures, etc. that perform particular tasks or implement particular abstract data types. Moreover, those skilled in the art will appreciate that other embodiments of the invention may be practiced in communication network environments with many types of communication equipment and computer system configurations, including personal computers, hand-held devices, multi-processor systems, microprocessor-based or programmable consumer electronics, and the like.

Embodiments may also be practiced in distributed computing environments where tasks are performed by local and remote processing devices that are linked (either by hardwired links, wireless links, or by a combination thereof) through a communications network. In a distributed computing environment, program modules may be located in both local and remote memory storage devices.

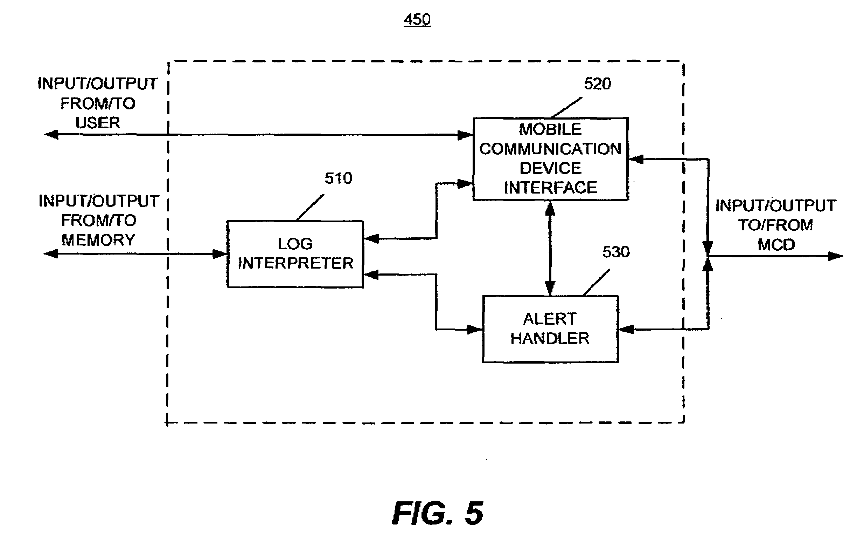

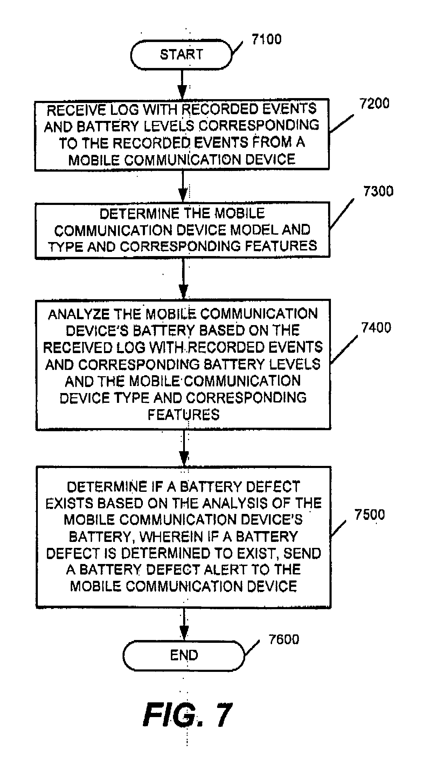

For illustrative purposes, the operation of the battery diagnostic module 450 and the battery diagnostic process are described in FIGS. 5 and 7 in relation to the block diagrams shown in FIGS. 1 and 4.

FIG. 5 illustrates an exemplary block diagram of a battery diagnostic module 450 in accordance with a possible embodiment of the disclosure. The battery diagnostic module 450 may include log interpreter 510, mobile communication device interface 520, and alert handler 530.

The mobile communication device interface 520 may manage the interaction with mobile communication devices 120. The mobile communication device interface 520 may have the ability to request logs from mobile communication devices 120, receive logs sent by mobile communication devices 120, extract the data from the received and forward it to other elements of the battery diagnostic module 450, such as the log interpreter 510, for example, and send commands to a mobile communication device 120 to remotely launch an application. Launching an application remotely may be upon request by either a user using the user interface as part of the input devices 460, or from the log interpreter 510, for example.

The mobile communication device interface 520 may allow a user (e.g., a Service Centre Agent or Quality Team Member) to create some policies that will be stored in memory 430, send a policy to a given mobile communication device 120, request a given mobile communication device 120 to send logs, and receive the logs sent by the mobile communication devices 120, for example.

The alert handler 530 may receive the alerts coming from the mobile communication devices 120. The data from the received alerts may be extracted and forwarded to the log interpreter 510 or the user through a user interface, for example.

The log interpreter 510 may receive the logs of the mobile communication devices 120 coming either from the mobile communication device interface 520 or from the alert handler 530. The logs may be stored on a per user basis using the memory 430 and statistics relevant for the received logs (same phone model, same event, ...) may also be gathered and stored. Depending on the gap between the logs received from the mobile communication devices 120 and the statistic/reference data, the log interpreter 510 may request more details or update the mobile communication devices policies using the mobile communication device interface 520.

FIG. 6 is an exemplary flowchart illustrating one possible battery consumption tracking process in accordance with one possible embodiment of the disclosure. This process may be performed by elements of the battery consumption tracking module 280. The process begins at step 6100 and continues to step 6200 where the event recorder 310 may record events occurring within in the mobile communication device 120. The events may be application launch/shutdown, turning on/off the mobile communication device 120, etc. Applications may include any functionality of the mobile communication device 120, including but not limited to telephone, Internet, text messaging, e-mail, MP3 player, radio, camera, Global Positioning System (GPS), calculator, calendar, etc., or any functions within these applications

At step 6300, the battery meter 320 may measure the battery level at a time of the recorded event. At step 6400, the event interpreter 340 may log the recorded events and the corresponding battery levels. At step 6500, the server interface 380 may output the logged corresponding events and measured battery levels for processing by a battery diagnostic server 130. The process then goes to step 6600 and ends.

FIG. 7 is an exemplary flowchart illustrating one possible battery diagnostic process in accordance with one possible embodiment of the disclosure. The process may be performed by elements of the battery diagnostic module 450, for example. The process begins at step 7100 and continues to step 7200 where the mobile communication device interface 520 may receive a log with recorded events and battery levels corresponding to the recorded events from the mobile communication device 120.

At step 7300, the log interpreter 510 may determine the mobile communication device model and type and corresponding features included with the mobile communication device 120. At step 7400, the log interpreter 510 may analyze the mobile communication device's battery based on the received log with recorded events and corresponding battery levels and the mobile communication device type and corresponding features.

At step 7500, the log interpreter 510 may determine if a battery defect exists based on the analysis of the mobile communication device's battery. If a battery defect is determined to exist, then at the mobile communication device interface 520 sends a battery defect alert to the mobile communication device 120. The process then goes to step 7600 and ends.

Embodiments within the scope of the present disclosure may also include computer-readable media for carrying or having computer-executable instructions or data structures stored thereon. Such computer-readable media can be any available media that can be accessed by a general purpose or special purpose computer. By way of example, and not limitation, such computer-readable media can comprise RAM, ROM, EEPROM, CD-ROM or other optical disk storage, magnetic disk storage or other magnetic storage devices, or any other medium which can be used to carry or store desired program code means in the form of computer-executable instructions or data structures. When information is transferred or provided over a network or another communications connection (either hardwired, wireless, or combination thereof) to a computer, the computer properly views the connection as a computer-readable medium. Thus, any such connection is properly termed a computer-readable medium. Combinations of the above should also be included within the scope of the computer-readable media.

Computer-executable instructions include, for example, instructions and data which cause a general purpose computer, special purpose computer, or special purpose processing device to perform a certain function or group of functions. Computer-executable instructions also include program modules that are executed by computers in stand-alone or network environments. Generally, program modules include routines, programs, objects, components, and data structures, etc. that perform particular tasks or implement particular abstract data types. Computer-executable instructions, associated data structure, and program modules represent examples of the program code means for executing steps of the methods disclosed herein. The particular sequence of such executable instructions or associated data structures represents examples of corresponding acts for implementing the functions described in such steps.

Although the above description may contain specific details, they should not be construed as limiting the claims in any way. Other configurations of the described embodiments of the disclosure are part of the scope of this disclosure. For example, the principles of the disclosure may be applied to each individual user where each user may individually deploy such a system. This enables each user to utilize the benefits of the disclosure even if any one of the large number of possible applications do not need the functionality described herein. In other words, there may be multiple instances of the battery consumption tracking module 280 in FIGS. 2 and 3, and the battery diagnosis module 450 in FIGS. 4 and 5, each processing the content in various possible ways. It does not necessarily need to be one system used by all end users. Accordingly, the appended claims and their legal equivalents should only define the disclosure, rather than any specific examples given.

## Claims

1. A method for tracking battery consumption in a mobile communication device, comprising:
recording events occurring within in the mobile communication device;
measuring a battery level of the mobile communication device at a time of the recorded event;
logging the recorded events and the measured battery levels corresponding to the recorded events; and
outputting the logged corresponding events and measured battery levels for processing by a battery diagnostic server.

2. The method of claim 1, wherein the recorded events are one of application start, application end, turning on of the mobile communication device, and turning off of the mobile communication device, applications being any functionality of the mobile communication device, including one of telephone, Internee text messaging, e-mail, MP3 player, radio, camera, Global Positioning System (GPS), calculator, calendar, and any functions within an application.

3. The method of claim 1, further comprising:
determining if a battery charger is charging the battery of the mobile communication device.

4. The method of claim 1, further comprising:
receiving policies from the battery diagnostic server; and
implementing the received policies.

5. The method of claim 1, further comprising:
providing at least one of battery statistics and alerts to at least one of a user of the mobile communication device and the battery diagnostic server.

6. A battery consumption tracking module that cracks battery consumption in a mobile communication device, comprising:
an event recorder that records events occurring within in the mobile communication device;
a battery meter that measures a battery level of the mobile communication device corresponding to a time of the logged event;
an event interpreter that logs the recorded events and the measured battery levels corresponding to the recorded events; and
a server interface that outputs the logged corresponding events and measured battery levels for processing by a battery diagnostic server.

7. The battery consumption tracking module of claim 6, wherein the recorded events are one of application start, application end, turning on of the mobile communication device, and turning off of the mobile communication device, applications being any functionality of the mobile communication device, including one of telephone, Internet, text messaging, e-mail, MP3 player, radio, camera, Global Positioning System (GPS), calculator, calendar, and any functions within an application.

8. The battery consumption tracking module of claim 6, further comprising:
a charger presence detector that determining if a battery charger is charging the battery of the mobile communication device and notifies the event interpreter.

9. The battery consumption tracking module of claim 6, further comprising:
a policy/threshold manager that receives policies from the battery diagnostic server through the server interface, wherein the event interpreter implements the received policies based upon input from the policy/threshold manager.

10. The battery consumption tracking module of claim 6, further comprising:
an alert handler that provides at least one of battery statistics and alerts to at least one of a user of the mobile communication device and the battery diagnostic server.

11. A method for performing a diagnosis of a battery in a mobile communication device, comprising:
receiving a log with recorded events and battery levels corresponding to the recorded events from the mobile communication device;
determining the mobile communication device model and type and corresponding features included with the mobile communication device;
analyzing the mobile communication device's battery based on the received log with recorded events and corresponding battery levels and the mobile communication device type and corresponding features; and
determining if a battery defect exists based on the analysis of the mobile communication device's battery, wherein if a battery defect is determined to exist,
sending a battery defect alert to the mobile communication device.

12. The method of claim 11, further comprising:
querying the mobile communication device for a log.

13. The method of claim 11, further comprising:
sending commands to the mobile communication device to launch an application.

14. The method of claim 11, further comprising:
determining policies concerning batteries for mobile communication devices; and
sending the policies to the mobile communication device.

15. The method of claim 11, further comprising:
storing the received log in a memory.

16. A battery diagnostic module in a battery diagnosis server, comprising:
a mobile communication device interface that receivers a log with recorded events and battery levels corresponding to the recorded events from the mobile communication device; and
a log interpreter that determines the mobile communication device model and type and corresponding features included with the mobile communication device, analyzes the mobile communication battery based on the received log with recorded events and corresponding battery levels and the mobile communication device type and corresponding features, and determines if a battery defect exists based on the analysis of the mobile communication device's battery, wherein if the log interpreter determines that a battery defect exists, the mobile communication device interface sends a battery defect alert to the mobile communication device.

17. The battery diagnostic module of claim 16, wherein the mobile communication device interface queries the mobile communication device for a log.

18. The battery diagnostic module of claim 16, wherein the mobile communication device interface sends commands to the mobile communication device to launch an application.

19. The battery diagnostic module of claim 16, wherein the log interpreter determines policies concerning batteries for mobile communication devices, and sends the policies to the mobile communication device using the mobile communication device interface.

20. The battery diagnostic module of claim 16, further comprising:
a memory that stores the received log.
